# EUROPÄISCHE PATENTANMELDUNG

(11) **EP 1 501 125 A2**
(43) Veröffentlichungstag der Anmeldung: **26.01.2005**
(21) Anmeldenummer: 04014432.1
(22) Anmeldetag: 19.06.2004
(51) Int. Cl.: H01L 23/373, H01L 23/52, H01L 25/07

(54) **Leistungshalbleitermodul mit skalierbarer Aufbautechnik**

(30) Priorität: 23.07.2003 DE 10333328
(71) Anmelder: Semikron Elektronik GmbH Patentabteilung, 90253 Nürnberg (DE)
(72) Erfinder: Manz, Yvonne, 91085 Weisendorf (DE); Steger, Jürgen, 91355 Hilpoltstein (DE); Stockmeier, Thomas, Dr., 90431 Nürnberg (DE)

(57) **Zusammenfassung**

Die Erfindung beschreibt ein Leistungshalbleitermodul (10) in skalierbarer Aufbautechnik mit einer Grundplatte (20) oder zur direkten Montage auf einem Kühlkörper bestehend aus einem rahmenartigen Gehäuse (30), einem Deckel, nach außen führenden Anschlusselementen für Lastkontakte (40,42,44) und Hilfskontakte und mit mindestens zwei innerhalb des Gehäuses (30) angeordneten elektrisch isolierenden Substraten (50). Die Substrate bestehen aus je einem Isolierstoffkörper (52) und einer auf dessen der Grundplatte (20) oder dem Kühlkörper abgewandten ersten Hauptfläche befindlichen Mehrzahl von gegeneinander elektrisch isolierten metallischen Verbindungsbahnen (54), sowie darauf befindlichen und mit diesen Verbindungsbahnen schaltungsgerecht verbundenen Leistungshalbleiterbauelementen (56). Alle Substrate (50) sind vollständig identisch ausgestaltet. Alle Substrate (50) sind miteinander elektrisch leitend verbunden und auf allen Substraten (50) ist die gleiche Art und Anzahl von Leistungshalbleiterbauelementen (56) angeordnet.

## Beschreibung

Die Erfindung beschreibt ein Leistungshalbleitermodul bestehend aus einem Gehäuse mit Grundplatte und mindestens einem darin angeordneten elektrisch isolierenden Substrat. Dieses besteht seinerseits aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Vorteilhafterweise weist das Substrat auf seiner Unterseite eine flächige metallische Schicht, vergleichbar den Verbindungsbahnen, auf. Weiterhin weisen derartige Leistungshalbleitermodule Anschlusselemente für Last- und Hilfskontakte auf.

Leistungshalbleitermodule, die Ausgangspunkt dieser Erfindung sind, sind beispielhaft bekannt aus der DE 103 16 355. Derartige Leistungshalbleitermodule weisen definierte Spannungs- und Leistungsklassen auf. Beispielhaft sind die Spannungsklassen 600V, 1200V und 1700V bekannt. In gleicher Weise sind auch verschiedene Leistungsklassen bekannt. Um einen breiten Einsatzbereich abdecken zu können werden somit diesen Klassen entsprechende Leistungshalbleitermodule angeboten. Um bei gegebener Vielfalt eine rationelle Fertigung gewährleisten zu können werden Leistungshalbleitermodule in gleichartiger äußerer Form mit gleichartigen Anschlusselementen für unterschiedliche Klassen, sowohl Spannungs- als auch Leistungsklassen, angeboten. Diese unterscheiden sich abhängig von den jeweiligen Klassen in der Anzahl und der Art der darin enthaltenen Leistungshalbleiterbauelemente, in der Ausgestaltung der Substrate sowie in weiteren Funktionalitäten wie beispielhaft integrierten Sensorikbauteilen. Den Stand der Technik bilden Leistungshalbleiterbauelemente, die für unterschiedliche Leistungsklassen eine unterschiedliche Anzahl von Substraten enthalten. Diese Substrate unterscheiden sich untereinander, beispielhaft dadurch, ob Leiterbahnen für weitere Funktionalitäten wie Sensorikbauteile auf ihnen angeordnet sind, ob ein Sensorikbauteil auf dem Substrat angeordnet ist, wie die internen Verbindungen zu extemen Anschlüssen angeordnet sind oder wie die Substrate intern miteinander verbunden sind. Leistungshalbleitermodule für unterschiedliche Klassen unterscheiden sich daher bei ähnlichem äußeren Aufbau signifikant in ihrem inneren Aufbau. Dies ist nachteilig für eine automatisierte Produktion, da sowohl für unterschiedliche Leistungs- als auch für unterschiedliche Spannungsklassen unterschiedliche Substrate verwendet werden.

Der vorliegenden Erfindung liegt daher die Aufgabe zu Grunde ein Leistungshalbleitermodul vorzustellen, das in einfacher Weise skalierbar ist und somit Leistungshalbleitermodule unterschiedlicher Leistung mit einer Vielzahl gleicher Komponenten aufgebaut werden kann.

Diese Aufgabe wird gelöst durch ein Leistungshalbleitermodul nach dem Anspruch 1, spezielle Ausgestaltungen finden sich in den Unteransprüchen.

Der Grundgedanke der Erfindung geht aus von einem Leistungshalbleitermodul mit einer Grundplatte oder zur direkten Montage auf einem Kühlkörper nach dem genannten Stand der Technik bestehend aus einem rahmenartigen Gehäuse mit mindestens einem darin angeordneten elektrisch isolierenden Substrat. Dieses Substrat besteht seinerseits aus einem Isolierstoffkörper mit einer Mehrzahl von auf seiner ersten Hauptfläche befindlichen gegeneinander isolierten metallischen Verbindungsbahnen sowie vorzugsweise aus einer auf seiner zweiten Hauptfläche angeordneten flächigen metallischen Schicht. Auf den Verbindungsbahnen der ersten Hauptfläche und mit diesen Verbindungsbahnen schaltungsgerecht verbunden ist eine Mehrzahl von Leistungshalbleiterbauelementen angeordnet. Das Leistungshalbleitermodul weist weiterhin nach außen führende Anschlusselemente für Last- und Hilfskontakte auf.

Das erfinderische Leistungshalbleitermodul weist je nach Leistungsklasse eine Mehrzahl identischer Substrate mit gleicher Anordnung der Leistungshalbleiterbauelemente auf. Weiterhin weist jedes Substrat weitere Leiterbahnen zur Anordnung mindestens eines Sensorikbauteils auf, wobei auf mindestens einem Substrat ein Sensorikbauteil angeordnet ist.

Vorteilhaft an dieser Ausgestaltung eines Leistungshalbleitermoduls ist, dass durch die völlig identischen Substrate und die Bestückung mit Leistungshalbleiterbauelementen das Modul einer rationellen Fertigung zugänglich ist, da für unterschiedliche Leistungsklassen nur die Anzahl der im Leistungshalbleitermodul angeordneten Substrate variiert. Auch zusätzliche Funktionalitäten wie Sensorikbauteile sind einfach zu integrieren, da die dafür benötigten Leiterbahnen auf jedem Substrat gleichartig vorgesehen sind. Somit gibt es innerhalb des Leistungshalbleitermoduls ausschließlich einen Unterschied in der Bestückung, nicht aber in der Art oder der Gestalt der Substrate. Die Anschlussflächen für Verbindungselemente zur internen und externen Verbindung der Last- und Hilfsanschlüsse sind somit ebenfalls auf allen Substraten identisch.

Die Erfindung wird anhand von Ausführungsbeispielen in Verbindung mit den Fig. 1 bis 4 näher erläutert.
- Fig. 1: zeigt ein Leistungshalbleitermodul nach dem Stand der Technik in Draufsicht.
- Fig. 2: zeigt ein erfindungsgemäßes Leistungshalbleitermodul in Draufsicht.
- Fig. 3: und 4 zeigen je ein weiteres erfindungsgemäßes Leistungshalbleitermodul unterschiedlicher Leistungsklasse in Draufsicht.

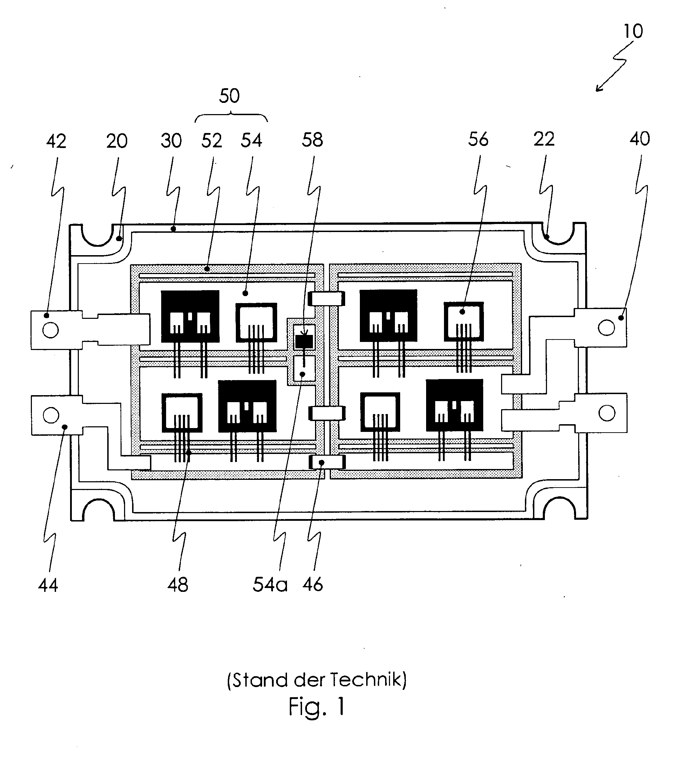

Fig. 1 zeigt ein Leistungshalbleitermodul nach dem Stand der Technik in Draufsicht. Dargestellt ist ein Leistungshalbleitermodul (10) bestehend aus einer Grundplatte (20) zur Montage auf einem Kühlkörper. Hierzu weist diese Grundplatte (20) im Bereich ihrer Ecken jeweils eine Ausnehmung (22) auf. Das Modul besteht weiterhin aus einem rahmenartigen Gehäuse (30) sowie zwei elektrisch isolierenden Substraten (50). Das jeweilige Substrat besteht seinerseits aus einem Isolierstoffkörper (52) mit einer Mehrzahl von auf seiner ersten der Grundplatte (20) abgewandten Hauptfläche befindlichen gegeneinander isolierten metallischen Verbindungsbahnen (54). Auf seiner zweiten der Grundplatte zugewandten Hauptfläche weist das Substrat eine den Verbindungsbahnen der ersten Hauptfläche gleichartige flächige Metallisierung auf. Auf den Verbindungsbahnen (54) und mit diesen schaltungsgerecht mittels Drahtbondverbindungen (48) verbunden sind Leistungshalbleiterbauelemente (56), sowie ein Sensorikbauteil (58) angeordnet. Zur elektrischen Kontaktierung weist das Teilmodul (10) Anschlusselemente (40, 42, 44) für die Lastanschlüsse auf. Die Anschlusselemente (42, 44) sind hierbei die Gleichstromanschlüsse, das Wechselstromanschlusselement (40) ist hier doppelt ausgeführt.

Die Verbindungsbahnen (54) der Substrate (50) sind zum Teil miteinander und mit den Anschlusselementen (40) direkt oder mittels Lötbrücken (46) miteinander verbunden. Für das Sensorikbauteil (58) sowie zu dessen externer Kontaktierung nach dem Stand der Technik weist eines der Substrate weiteren Leiterbahnen (54a) auf. Beide innerhalb des Leistungshalbleitermoduls angeordnete Leiterbahnen weisen somit auf Grund ihrer unterschiedlichen Funktionalität eine unterschiedliche Gestaltung auf.

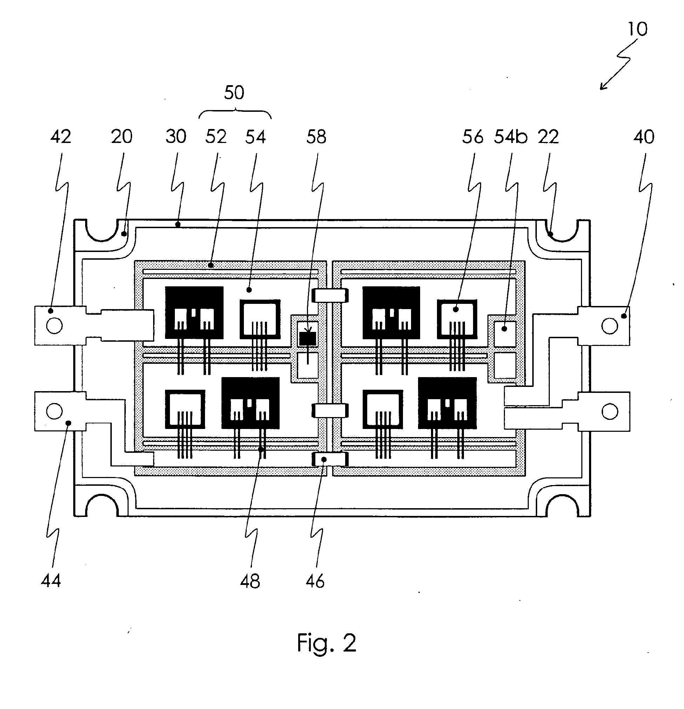

Die Fig. 2 bis 4 zeigen je ein erfindungsgemäßes Leistungshalbleitermodul (10) in Draufsicht. Dieses unterscheidet sich vom in Fig. 1 dargestellten Stand der Technik dadurch, dass alle Substrate (50), unabhängig von der mit der Leistungsklasse skalierenden Anzahl der Substrate, jeweils vollständig identisch ausgestaltet sind. Identisch sind hier die Größe und Art des Isolierstoffkörpers (52) sowie die Anordnung und Art aller Verbindungsbahnen (54).

Weiterhin weisen alle Substrate jeweils die gleiche Anzahl und Art von Leistungshalbleiterbauelementen (56) auf. Der einzige Unterschied liegt in der Bestückung der jeweiligen Substrate mit weiteren Bauelementen, hier Sensorikbauteilen (58).

Fig. 2 zeigt ein Leistungshalbleitermodul (10) mit zwei Substraten (50). Beide weisen die gleiche Anzahl und Ausgestaltung der Verbindungsbahnen (54) einschließlich der weiteren Verbindungsbahnen (54b) für weitere Funktionalitäten, wie hier das Sensorikbauteil (58), auf.

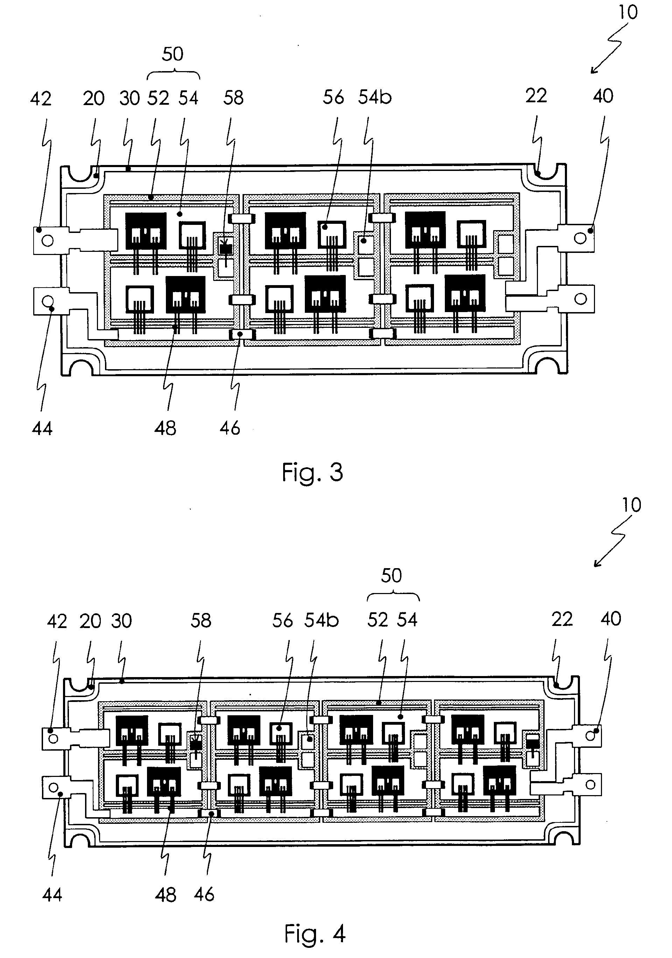

Fig. 3 zeigt ein Leistungshalbleitermodul (10) mit 50% höherer Leistungsfähigkeit verglichen mit demjenigen aus Fig. 2. Beide unterscheiden sich ausschließlich in der Länge des Leistungshalbleitermoduls (10) selbst und in der darin angeordneten Anzahl der Substrate (50). Hierbei weist weiterhin ein Substrat ein Sensorikbauteil (58) auf den weiteren Leiterbahnen (54b) auf. Die beiden weiteren Substrate (50) weisen wohl die Leiterbahnen (54b) auf, diese sind allerdings hier nicht mit Bauteilen bestückt.

Fig 4 zeigt ein Leistungshalbleitermodul (10) mit der doppelten Leistungsfähigkeit verglichen mit demjenigen aus Fig. 2. Auch hier erfolgt die Skalierung bei gleicher Ausgestaltung der äußeren Anschlüsse (40, 42, 44) und sowie der internen Verbindung der Substrate (50) durch Lötverbinder (46) ausschließlich über eine größere Länge des Moduls sowie durch die Anordnung weiterer identischer Substrate (50). Hierbei sind zwei Substrate mit Sensorikbauteilen (58) auf weiteren Leiterbahnen (54b) bestückt, während die beiden anderen Substrate ebenfalls diese weiteren Leiterbahnen (54b) aufweisen, allerdings ohne darauf angeordnete Bauteile.

## Patentansprüche

1. Leistungshalbleitermodul (10) in skalierbarer Aufbautechnik mit einer Grundplatte (20) oder zur direkten Montage auf einem Kühlkörper bestehend aus einem rahmenartigen Gehäuse (30), einem Deckel (70), nach außen führenden Anschlusselementen für Last-(40, 42, 44) und Hilfskontakte und mit mindestens zwei innerhalb des Gehäuses (30) angeordneten elektrisch isolierenden Substraten (50), die ihrerseits bestehen aus je einem Isolierstoffkörper (52) und auf dessen der Grundplatte (20) oder dem Kühlkörper abgewandten ersten Hauptfläche befindlichen Mehrzahl von gegeneinander elektrisch isolierten metallischen Verbindungsbahnen (54), darauf befindlichen und mit diesen Verbindungsbahnen schaltungsgerecht verbundenen Leistungshalbleiterbauelementen (56), wobei alle Substrate (50) vollständig identisch ausgestaltet sind, alle Substrate (50) miteinander elektrisch leitend verbunden sind und auf allen Substraten (50) die gleiche Art und Anzahl von Leistungshalbleiterbauelementen (56) angeordnet ist und weiterhin jedes Substrat (50) mindestens eine weitere Leiterbahn (54b) zur Anordnung eines Sensorikbauteils aufweist und auf mindestens einem Substrat ein Sensorikbauteil (58) angeordnet ist.

2. Leistungshalbleitermodul (10) nach Anspruch 1, wobei
die Grundplatte (20) eine Mehrzahl von Ausnehmungen (22) zur Schraubverbindung des Leistungshalbleitermoduls mit dem Kühlkörper aufweist.

3. Leistungshalbleitermodul (10) nach Anspruch 1, wobei
der Isolierstoffkörper (52) des Substrates (50) auf seiner zweiten der Grundplatte (20) oder dem Kühlkörper zugewandten Hauptfläche eine den Verbindungsbahnen (54) der ersten Hauptfläche gleichartige flächige Metallisierung (53) aufweist.

4. Leistungshalbleitermodul nach Anspruch 4, wobei
eine stoffbündige Verbindung der Grundplatte (20) mit der metallischen Schicht der Substrate (50) aus flächig ausgeführten Lötungen besteht.

5. Leistungshalbleitermodul (10) nach Anspruch 1, wobei
die gleichartigen Substrate (50) untereinander mittels Lötbrücken (46) verbunden sind.
